(19) Europäisches Patentamt / European Patent Office / Office européen des brevets

(11) **EP 3 988 947 B1**

(12) **EUROPEAN PATENT SPECIFICATION**

(45) Date of publication and mention of the grant of the patent:
**13.11.2024 Bulletin 2024/46**

(21) Application number: **20827895.2**

(22) Date of filing: **22.06.2020**

(51) International Patent Classification (IPC):
**G01R 31/52** (2020.01)     **H02S 50/00** (2014.01)
**G01R 27/18** (2006.01)

(52) Cooperative Patent Classification (CPC):
**H02S 50/00; G01R 27/18; G01R 31/52;** Y02E 10/50

(86) International application number:
**PCT/CN2020/097483**

(87) International publication number:
**WO 2020/253876 (24.12.2020 Gazette 2020/52)**

(54) **CIRCUIT AND METHOD FOR DETECTING INSULATION RESISTANCE OF PHOTOVOLTAIC ARRAY TO GROUND**

SCHALTUNG UND VERFAHREN ZUR BESTIMMUNG DES ISOLATIONSWIDERSTANDES EINER FOTOVOLTAISCHEN ANORDNUNG GEGEN ERDE

CIRCUIT ET PROCÉDÉ DE DÉTECTION DE RÉSISTANCE D'ISOLATION DE RÉSEAU PHOTOVOLTAÏQUE À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.06.2019 CN 201910535899**

(43) Date of publication of application:
**27.04.2022 Bulletin 2022/17**

(73) Proprietor: **Goodwe Technologies Co., Ltd.**
**Suzhou, Jiangsu 215011 (CN)**

(72) Inventors:
- **LIU, Song**
  **Suzhou, Jiangsu 215011 (CN)**
- **HUANG, Min**
  **Suzhou, Jiangsu 215011 (CN)**
- **FANG, Gang**
  **Suzhou, Jiangsu 215011 (CN)**
- **LU, Jinjun**
  **Suzhou, Jiangsu 215011 (CN)**
- **JIANG, Feng**
  **Suzhou, Jiangsu 215011 (CN)**
- **YUAN, Hong**
  **Suzhou, Jiangsu 215011 (CN)**

(74) Representative: **Meissner Bolte Partnerschaft mbB**
**Patentanwälte Rechtsanwälte**
**Postfach 86 06 24**
**81633 München (DE)**

(56) References cited:
| | |
|---|---|
| CN-A- 102 298 091 | CN-A- 103 904 994 |
| CN-A- 104 702 208 | CN-A- 104 977 471 |
| CN-A- 105 004 979 | CN-A- 105 938 162 |
| CN-A- 108 490 258 | CN-A- 110 412 352 |
| CN-U- 202 994 907 | CN-U- 203 941 235 |
| CN-U- 208 000 342 | US-A1- 2015 084 654 |
| US-A1- 2018 011 149 | US-B2- 9 024 646 |

**Description**

Technical Field of the Invention

The present disclosure relates to the field of power and electron technology, and particularly relates to a circuit and a method for detecting the insulation resistance to ground of a photovoltaic array, and a photovoltaic inverter based thereon.

Background of the Invention

At present, because non-isolated inverters do not have a transformer, the losses brought by transformer are reduced, and the conversion efficiency is greatly improved, while the circuit structure is simplified and the cost is saved. Accordingly, it is wildly popularized in the photovoltaic power generation system.

However, for considerations of electrical safety, the use of non-isolated inverters will result in a direct electrical connection between the photovoltaic array and the public grid. Therefore, it is necessary to detect the insulation resistance between the photovoltaic array and the public grid in time to prevent the insulation resistance of the photovoltaic array from being too small due to long-term sunlight, water, etc., which will lead to grid-connected safety accidents and cause personal and property losses.

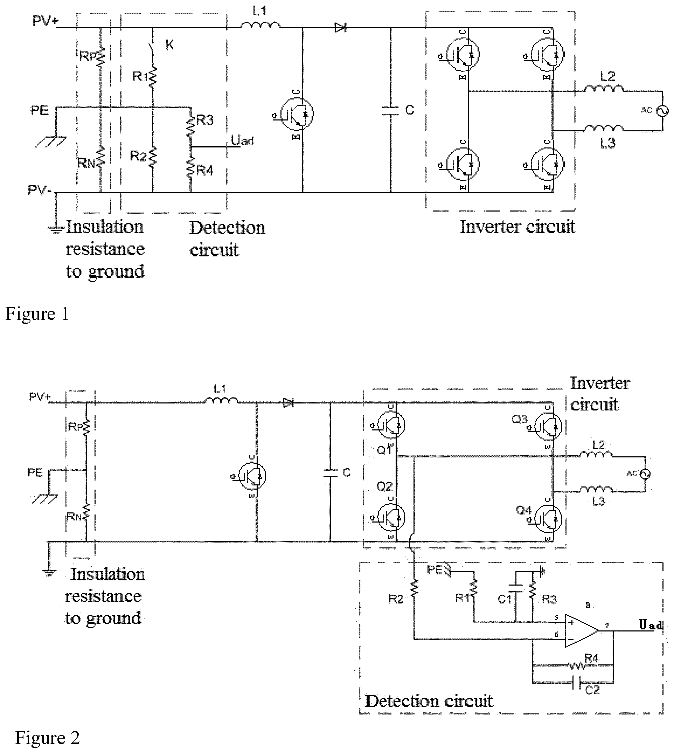

At present, the common method for detecting the insulation resistance to ground of a photovoltaic array is: connecting a detection circuit in parallel to the input end of an inverter (for multiple inputs, the same effect can be obtained through parallel connecting to the bus capacitor), changing the connection of the sense resistor by controlling the relay in the detection circuit to form an unbalanced bridge, and calculating the voltage at the divider resistance to calculate the insulation resistance. By properly changing the positions of the relay and the sense resistor, different detection circuits and algorithms can be obtained. One of the detection circuits is shown in Figure 1. Based on this detection circuit, a detection method is:

Step 1, assuming the voltage of the photovoltaic array is constant as U, when the relay K is turned off, $U_{ad}$=U1 is measured:

$$U1 = U * \frac{RN//R2//(R3+R4)}{RN//R2//(R3+R4)+RP} * \frac{R4}{R3+R4} \tag{1}$$

Step 2, assuming the voltage of the photovoltaic array is constant as U, when the relay K is turned on, $U_{ad}$=U2 is measured:

$$U2 = U * \frac{RN//R2//(R3+R4)}{RN//R2//(R3+R4)+(RP//R1)} * \frac{R4}{R3+R4} \tag{2}$$

RP and RN can be solved from formulas (1) and (2).

The prior art mentioned above exists the following problems:

1. It requires the relay and the related drive circuit to realize the said detection circuit, therefore the volume and the complexity of the inverter will be increased, and thus the cost of the inverter is increased. Particularly with the input voltage of current PV getting higher, the specification requirement on the relay is higher, and the cost and the complexity of the inverter is greatly increased; and this problem could be solved by US 2015/084654A1(See fig. 1, par.0008 and 0025 thereof) and US 2018/011149A1(See fig.5, par.0045 thereof), wherein the former refers to insulation resistance measurement for inverters having at least one half-bridge including two active switching elements for driving an output current, and a DC link voltage, a center point of the half-bridge positioned between the switching elements is connected to a grounding point by closing a grounding switch, and the center point connected to the grounding point is connected, one after the other, to a first ungrounded terminal and a second ungrounded terminal of the DC link voltage of the inverter present at the half-bridge by means of the two active switching elements of the half-bridge to establish a connection between the first and second ungrounded terminals, respectively, and the grounding point; and the latter refers to DC-AC converting circuit electrically coupled to the DC-DC converting circuit and configured to convert the DC bus voltage to an AC voltage, which is electrically coupled between the DC-DC converting circuit and the DC-AC converting circuit;

2. The computational formula is relatively complicated, which increases the calculation of the control chip of the inverter;

3. It requires the control of multiple relays to achieve multiple inputs, while the calculation will be multiplied, and occupy the resource of the control chip;

4. While adding components and elements, the failure probability of the inverter would be increased.

Patent document in prior art are provided, such as CN 105938162B, which relates to the field of photovoltaic inverter technology and discloses a system for detecting insulation resistance to ground based on a two-way mppt photovoltaic inverter;

CN 103904994B, which relates to The present invention relates to a leakage current detection method, comprising: obtaining the resistance of the positive electrode-to-ground insulation resistance of the target DC power supply and the resistance of the negative electrode-to-ground insulation resistance by measurement; According to the resistance value of the positive electrode-to-ground insulation resistance and the resistance of the negative electrode-to-ground insulation resistance, the capacitance value of the ground parasitic capacitance of the target DC power supply is obtained; The differential sampling circuit is used to obtain at least one of the positive to ground voltage change rate and negative pole to ground voltage change rate of the target DC power supply; According to the positive electrode-to-ground voltage change rate, at least one of the negative electrode-to-ground voltage change rate, and the capacitance value of the parasitic capacitance to ground, the ground leakage current of the target DC power supply is obtained.

Summary of the Invention

The present disclosure is aimed to provide a system for detecting insulation resistance to ground of a photovoltaic array, thereby having relatively low complexity, low cost, and easier calculation, and ensuring the function of an inverter.

The invention is set out in independent claims 1, 9 and 12. Further advantageous embodiments are defined by the dependent claims.

Due to the use of the above technical solutions, the present disclosure has the following advantages over the prior art: The present disclosure uses the original switching tubes and the drive circuit of the inverter rather than a relay and a corresponding drive circuit or any additional components, which greatly saves the machine space and cost, at the same time reduces the failure probability introduced by components such as relays. The computational formula based on this detection circuit is simpler, which decreases the calculation of the control chip of the inverter.

Brief Description of the Drawings

For more clearly explaining the technical solutions in the embodiments of the present disclosure, the accompanying drawings used to describe the embodiments are simply introduced in the following. Apparently, the below described drawings merely show a part of the embodiments of the present disclosure, and those skilled in the art can obtain other drawings according to the accompanying drawings without creative work.

Figure 1 is a circuit diagram of a circuit for detecting the insulation resistance to ground of a photovoltaic array in the prior art;

Figure 2 is a circuit diagram of a circuit for detecting the insulation resistance to ground of a photovoltaic array provided by an embodiment of the present disclosure;

Figure 3 is an equivalent circuit diagram of the circuit for detecting the insulation resistance to ground of the photovoltaic array in Figure 2.

Detailed Description of Exemplary Embodiments

In order to enable those skilled in the art to better understand the solutions of the present disclosure, and to better understand the purposes, the technical solution and the advantages of the disclosure, the technical solutions in the embodiments of the present disclosure are explained clearly and completely below in conjunction with the specific embodiments and referring to accompanying drawings. It should be noted that the implementation manners that are not depicted or described in the drawings are those that are known to those of ordinary skill in the art. In addition, although this article may provide an example of a parameter containing a specific value, it should be understood that the parameter does not need to be exactly equal to the corresponding value, but can be approximated to a corresponding value within acceptable error tolerances or design constraints. Apparently, the described embodiments are merely a part of the embodiments of the present disclosure, not all the embodiments. In addition, the terms "comprise" and "have" and any variations thereof in the description and claims of the present disclosure are intended to cover non-exclusive inclusions, for example, processes, methods, devices, products or equipment that include a series of steps or units are not necessarily limited to those clearly listed steps or units, but may include other steps or units not explicitly listed or inherent to these processes, methods, products or equipment. It should also be noted that terms "first", "second" and the like in the description, the claims and the accompanying drawings of the present disclosure are used to distinguish similar objects, and do not have to be used to describe a specific order or sequence.

In the following, the present disclosure is further described combining with the embodiments shown in the accompanying drawings.

Embodiment 1: As shown in Figure 2, a system for detecting insulation resistance to ground of a photovoltaic array is provided, comprising a photovoltaic inverter, wherein the photovoltaic inverter comprises an inverter circuit connected to a photovoltaic array, the inverter circuit takes a single-phase full-bridge inverter circuit as an example, and the inverter circuit comprises a first switching tube Q1, a second switching tube Q2, a third switching tube Q3, and a fourth switching tube Q4. The first switching tube Q1 and the second switching tube Q2 are connected to form one bridge arm, and the third switching tube Q3 and the fourth switching tube Q4 are connected to form the other bridge arm.

The photovoltaic inverter is applied to a photovoltaic array, and the photovoltaic inverter further comprises a circuit for detecting the insulation resistance to ground of the photovoltaic array and an inverting control chip, and other functional circuits such as Boost circuit, etc.

The circuit for detecting the insulation resistance to ground of the photovoltaic array comprises a first resistor R1, a second resistor R2 and an operational amplifier, wherein one end of the first resistor R1 is connected to a non-inverting input end of the operational amplifier, and the other end of the first resistor R1 is connected to the grounding end of the insulation resistance to be detection; one end of the second resistor R2 is connected to an inverting input end of the operational amplifier, and the other end of the second resistor R2 is connected to the inverter circuit that is connected to the photovoltaic array by means of the following mode: the other end of the second resistor R2 is connected to the intermediate connection end of two switching tubes on a same bridge arm of the inverter circuit, that is, it may be that the connection end of the first switching tube Q1 and the second switching tube Q2 is connected to the other end of the second resistor R2, or it may be that the connection end of the third switching tube Q3 and the fourth switching tube Q4 is connected to the other end of the second resistor R2, and these two connection modes are essentially the same, and the former is described as an example below, as shown in Figure 2:

The circuit for detecting the insulation resistance to ground of the photovoltaic array comprises the first switching tube Q1 and the second switching tube Q2 in one bridge arm of the inverter circuit, and further comprises the two sense resistors R1, R2 and the operational amplifier, wherein the intermediate point of the first switching tube Q1 and the second switching tube Q2 (namely the connection point of the two) is connected to the inverting input end of the operational amplifier by means of a sense resistor (i.e., the second resistor R2), and a non-inverting input end of the operational amplifier is connected to protective grounding (i.e., the grounding end, namely PE end, of the insulation resistance to be detected in Figure 2) by means of the other sense resistor (i.e., the first resistor R1), and an output end of the operational amplifier forms a voltage detection end, that is, the insulation resistance to ground of the photovoltaic array can be detected by detecting the voltage at the output end of the operational amplifier. Furthermore, the detection circuit further comprises two matching capacitors (namely, a first capacitor C1 and a second capacitor C2), and two matching resistors (namely, a third resistor R3 and a fourth resistor R4), the first capacitor C1 and the third matching resistor R3 are connected in parallel between the shield grounding end and the non-inverting input end of the operational amplifier, that is, the first capacitor and the third resistor are connected in parallel to form a first parallel circuit, wherein one end of the first parallel circuit is connected to the non-inverting input end of the operational amplifier, and the other end of the first parallel circuit is connected to the shield grounding end; the second capacitor C2 and the fourth resistor R4 are connected in parallel between the inverting input end and the output end of the operational amplifier, that is, the second capacitor and the fourth resistor are connected in parallel to form a second parallel circuit, wherein one end of the second parallel circuit is connected to the inverting input end of the operational amplifier, and the other end of the second parallel circuit is connected to the output end of the operational amplifier. In this solution, the first switching tube Q1 and the second switching tube Q2 used in the inverter circuit may be replaced by the third switching tube Q3 and the fourth switching tube Q4 on the other bridge arm. It should be noted that the shield grounding end is the digital ground of a control board, the ground end, namely, the PE end is the ground, and there is a difference between the two.

In one preferred embodiment of the present disclosure, the resistance values of the first resistor R1 and the second resistor R2 are equal, the resistance values of the third resistor R3 and the fourth resistor R4 are equal, and the capacitance values of the first capacitor C1 and the second capacitor C2 are equal, in such a way, the symmetrical balance of the operational amplifier is realized. It should be noted that even if the above resistance values are not equal or the capacitance values are not equal, the technical solution of the present disclosure may be implemented, which only affects the accuracy of the circuit for detecting the insulation resistance to ground of the photovoltaic array provided by an embodiment of the present disclosure. The above R1=R2, R3=R4, and C1=C2 are only preferred embodiments for improving the detection accuracy of the detection circuit, and not as a limitation of the protection scope required by the present disclosure.

The inverting control chip is configured to control the first switching tube Q1, the second switching tube Q2, the third switching tube Q3 and the fourth switching tube Q4 to turn on or turn off, and is also connected to the voltage detection end for the voltage detection of the output end of the operational amplifier to obtain the output voltage $U_{ad}$, and finally, according to the output voltage of the photovoltaic array, the first resistance value, the second resistance value and the voltage value $U_{ad}$, calculate the insulation resistance to ground of the photovoltaic array.

It should be noted that for the case where the above-mentioned inverter circuit is a three-phase full-bridge inverter circuit, the technical solution of the present disclosure can also be implemented: the three-phase full-bridge inverter circuit comprises the first switching tube Q1 and the second switching tube Q2 in a first bridge arm, the third switching tube Q3 and the fourth switching tube Q4 in a second bridge arm, a fifth switching tube Q5 and a sixth switching tube Q6 in a third bridge arm (the fifth switching tube Q5 and the sixth switching tube Q6 are not shown). Like the above-mentioned single-phase full-bridge inverter circuit, one end of the second resistor R2 is connected to the inverting input end of the operational amplifier, the other end of the second resistor R2 is connected to the intermediate connection end of two switching tubes on any bridge arm of the inverter circuit, and Figure 2 only shows an embodiment where the second resistor R2 is connected to the intermediate connection end of the first switching tube Q1 and the second switching tube Q2 on the first bridge arm. Obviously, connecting the second resistor R2 to the intermediate connection end of the third switching tube Q3 and the fourth switching tube Q4 on the second bridge arm, or connecting the second resistor R2 to the intermediate connection end of the fifth switching tube Q5 (not shown) and the sixth switching tube Q6 (not shown) on the third bridge arm (not shown) is only simple equivalent replacement, which also falls within the protection scope of the present disclosure; the operating principle of the circuit for detecting the insulation resistance to ground of the photovoltaic array is as above, which would not be repeated.

For the case of the three-phase full-bridge inverter circuit, the inverting control chip is configured to control the first switching tube Q1, the second switching tube Q2, the third switching tube Q3, the fourth switching tube Q4, the fifth switching tube Q5 and the sixth switching tube Q6 to turn on or turn off.

The circuit for detecting the insulation resistance to ground of the photovoltaic array is moved from the PV end in the traditional detection circuit to the inverted circuit, uses switching tubes to replace the relays to switch, utilizes the characteristics of the operational amplifier to form a new unbalanced circuit, so as to calculate the insulation resistance to ground.

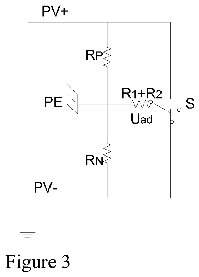

Before calculating the insulation resistance to ground, the detection circuit in Figure 2 is transformed into the equivalent circuit in Figure 3, and the equivalent principle is as follows:

On the one hand, the first switching tube Q1 and the second switching tube Q2 can be equivalent to a single-pole double-throw switch S; on the other hand, according to the characteristics of virtual short and virtual break of operational amplifier, its pin 5 and pin 6 can be directly shorted together, so that the first resistor R1 and the second resistor R2 are connected in series, and due to that one end of the first resistor R1 is connected to the PE end, i.e., the intermediate grounding end, namely, PE end of the two insulation resistances $R_P$ and $R_N$ to be detected, thereby the equivalent circuit is obtained as shown in Figure 3. When the first switching tube Q1 is turned off and the second switching tube Q2 is turned on, the equivalent single-pole double-throw switch S turns on the circuit on the side (the lower side in Figure 3) where the second switching tube Q2 is located; when the first switching tube Q1 is turned on and the second switching tube Q2 is turned off, the equivalent single-pole double-throw switch S turns on the circuit on the side (the upper side in Figure 3) where the first switching tube Q1 is located(such state is not shown).

A detection method used by the above-mentioned circuit for detecting the insulation resistance to ground of a photovoltaic array comprises the following steps:

Controlling the first switching tube to turn off and the second switching tube to turn on, to detect a first voltage at the output end of the operational amplifier; controlling the first switching tube to turn on and the second switching tube to turn off, to detect a second voltage at the output end of the operational amplifier; then according to the output voltage of the photovoltaic array, the first resistance, the second resistance, the first voltage, and the second voltage, calculating the value of insulation resistance to ground. It is specifically as follows:

Step 1: turning off the first switching tube Q1 and turning on the second switching tube Q2, which corresponds to switching the single-pole double-throw switch S to PV-, measuring the voltage across the sense resistor (that is, equivalent to the first resistor R1 and the second resistor R2 in series), measuring a first voltage $U_{ad}$=U1 at the voltage detection end, and assuming that the photovoltaic array voltage U is constant, making out a first formula at this time:

$$\frac{U1}{R1+R2} + \frac{U1}{R_N} = \frac{U-U1}{R_P} \qquad (3)$$

wherein, U1 is the first voltage value, U is the output voltage of the photovoltaic array, R1 is the first resistance value, R2 is the second resistance value, $R_P$ is the first insulation resistance value, and $R_N$ is the second insulation resistance value.

Step 2: turning on a first switching tube Q1 and turning off a second switching tube Q2, which corresponds to switching the single-pole double-throw switch S to PV+, measuring the voltage across the sense resistor (that is, equivalent to the first resistor R1 and the second resistor R2 in series), measuring a second voltage $U_{ad}$=U2 at the voltage detection end, and assuming that the photovoltaic array voltage U is constant, making out a second formula at this time:

$$\frac{U2}{R1+R2}+\frac{U2}{R_P}=\frac{U-U2}{R_N} \tag{4}$$

wherein, U2 is the second voltage value, U is the output voltage of the photovoltaic array, R1 is the first resistance value, R2 is the second resistance value, $R_P$ is the first insulation resistance value, and $R_N$ is the second insulation resistance value.

The above step 1 and step 2 can be interchanged in order.

In a preferred embodiment, the resistance of the first resistor and the resistance of the second resistor are equal, that is, R1+R2=2*R1 is substituted into the above step (3) and step (4), and the calculation formula is further simplified as follows:

$$\frac{U1}{2*R1}+\frac{U1}{R_N}=\frac{U-U1}{R_P} \tag{5}$$

$$\frac{U2}{2*R1}+\frac{U2}{R_P}=\frac{U-U2}{R_N} \tag{6}$$

Step 3, solving, according to the formula (5) and the formula (6), the value of insulation resistance to ground of the photovoltaic array, we can get

$$R_P=\frac{2*R1*(U-U1-U2)}{U1} \tag{7}$$

$$R_N=\frac{2*R1*(U-U1-U2)}{U2} \tag{8}$$

$R_P$ and $R_N$ are insulation resistances to ground of the photovoltaic array to be detected, and the timely detection of the insulation resistance between the directly electrically connected photovoltaic array and the public grid can effectively avoid electrical safety accidents and increase the wide range of applications of non-isolated inverters.

The present disclosure uses the inverter circuit in the photovoltaic array to build a circuit for detecting the insulation resistance to ground, which eliminates the need for relays to reduce costs; and through the equivalent circuit, the resistance calculation formulas are further simplified, the calculation of the control chip of the inverter is reduced, the failure probability of the inverter is greatly reduced, and the stable output of the photovoltaic network is ensured.

The embodiments described above are only for illustrating the technical concepts and features of the present disclosure, and are intended to make those skilled in the art being able to understand the present disclosure and thereby implement it, and should not be concluded to limit the protective scope of this disclosure.

**Claims**

1. A system for detecting insulation resistance to ground ($R_P$, $R_N$) of a photovoltaic array, is **characterized in that**, the system comprises an inverter circuit and a detection circuit, wherein the detection circuit comprises a first resistor (R1), a second resistor (R2) and an operational amplifier, the inverter circuit is connectable to a photovoltaic array, and the inverter circuit comprises a first switch element (Q1) and a second switch element (Q2) connected in series:

wherein one end of the first resistor (R1) is connected to a non-inverting input end of the operational amplifier, the other end of the first resistor (R1) is connected to the grounding end of the insulation resistance (RP, RN) to be detected; and

one end of the second resistor (R2) is connected to an inverting input end of the operational amplifier, the other end of the second resistor (R2) is connected to an intermediate connection end of the first switch element (Q1) and the second switch element (Q2);

an output end of the operational amplifier forms a voltage detection end.

2. The system according to claim 1, is **characterized in that**, the resistances of the first resistor is equal to that of the second resistor.

3. The system according to claim 1, is **characterized in that**, the detection circuit further comprises a first capacitor (C1), a second capacitor (C2), a third resistor (R3) and a fourth resistor (R4), wherein the first capacitor and the third resistor are connected in parallel to form a first parallel circuit, one end of the first parallel circuit is connected to the non-inverting input end of the operational amplifier, and the other end of the first parallel circuit is connected to the shield grounding end;

the second capacitor and the fourth resistor are connected in parallel to form a second parallel circuit, one end of the second parallel circuit is connected to the inverting input end of the operational amplifier, and the other end of the second parallel circuit is connected to the output end of the operational amplifier.

4. The system according to claim 3, is **characterized in that**, the resistances of the third resistor is equal to that of the fourth resistor, and the capacitance value of the first capacitor is equal to that of the second capacitor.

5. The system according to claim 1, is **characterized in that**, the first switch element and the second switch element are two switching tubes on any bridge arm of a single-phase full-bridge inverter circuit or a three-phase full-bridge inverter circuit.

6. The system according to claim 1, is **characterized in that**, by detecting the voltage at the output end of the operational amplifier, and according to the resistances of the first resistor and the second resistor, the value of the insulation resistance to ground can be calculated.

7. The system according to claim 1, is **characterized in that**, the detection circuit further comprises a chip for controlling the first switch element and the second switch element to turn on or turn off, and the chip is further configured to, according to the voltage at the output end of the operational amplifier, calculate the insulation resistance to ground.

8. The system according to claim 5, is **characterized in that**, further comprising an inverting control chip, which is configured to control switching tubes in the full-bridge inverter circuit to turn on or turn off, and the inverting control chip is further configured to, according to resistances of the first resistor and the second resistor in the detection circuit and the voltage at the output end of the operational amplifier, calculate the insulation resistance to ground of the photovoltaic array.

9. A method for detecting the insulation resistance to ground ($R_P$, $R_N$) based on the system according to any one of claims 1 - 8, is **characterized in that**, the method comprises the following steps:

    S1: controlling the first switch element (Q1) to turn off and the second switch element (Q2) to turn on, to detect a first voltage at the output end of the operational amplifier; controlling the first switch (Q1) to turn on and the second switch element (Q2) to turn off, to detect a second voltage at the output end of the operational amplifier;
    S2: according to the output voltage of the photovoltaic array, a first resistance value of a the first resistor (R1), a second resistance value of the second resistor (R2), the first voltage, and the second voltage, calculating the value of insulation resistance to ground ($R_P$, $R_N$).

10. The method for detecting the insulation resistance to ground according to claim 9, is **characterized in that**, the insulation resistance comprises a first insulation resistance and a second insulation resistance, and S2 comprises calculating the value of insulation resistance to ground according the following formula:

$$\frac{U1}{R1+R2} + \frac{U1}{R_N} = \frac{U-U1}{R_P} ,$$

$$\frac{U2}{R1+R2}+\frac{U2}{R_P}=\frac{U-U2}{R_N}$$ , wherein, U1 is the first voltage value, U2 is the second voltage value, U is the output voltage of the photovoltaic array, R1 is the first resistance value, R2 is the second resistance value, $R_P$ is the first insulation resistance value, and $R_N$ is the second insulation resistance value.

11. The method for detecting the insulation resistance to ground according to claim 9, is **characterized in that**, assuming resistances of the first resistor is equal to that of the second resistor, S2 comprises calculating the value of insulation resistance to ground according the following formula:

$$\frac{U1}{2*R1}+\frac{U1}{R_N}=\frac{U-U1}{R_P}$$ ,

$$\frac{U2}{2*R1}+\frac{U2}{R_P}=\frac{U-U2}{R_N}$$ , wherein, U1 is the first voltage value, U2 is the second voltage value, U is the output voltage of the photovoltaic array, R1 is the first resistance value, $R_P$ is the first insulation resistance value, and $R_N$ is the second insulation resistance value.

12. Use of the system according to any one of claims 1 - 8 adapted for a photovoltaic inverter or a photovoltaic system.


**Patentansprüche**

1. System zum Detektieren eines Isolierungswiderstands gegenüber Erdung ($R_P$, $R_N$) einer Photovoltaikanordnung, das **dadurch gekennzeichnet ist, dass** das System eine Wechselrichterschaltung und eine Detektionsschaltung umfasst, wobei die Detektionsschaltung einen ersten Widerstand (R1), einen zweiten Widerstand (R2) und einen Betriebsverstärker umfasst, die Wechselrichterschaltung mit einer Photovoltaikanordnung verbindbar ist und die Wechselrichterschaltung ein erstes Schaltelement (Q1) und ein zweites Schaltelement (Q2), die in Reihe verbunden sind, umfasst,

wobei ein Ende des ersten Widerstands (R1) mit einem nicht invertierenden Eingangsende des Betriebsverstärkers verbunden ist, das andere Ende des ersten Widerstands (R1) mit dem Erdungsende des zu detektierenden Isolierungswiderstands ($R_P$, $R_N$) verbunden ist, und
ein Ende des zweiten Widerstands (R2) mit einem invertierenden Eingangsende des Betriebsverstärkers verbunden ist, das andere Ende des zweiten Widerstands (R2) mit einem Zwischenverbindungsende des ersten Schaltelements (Q1) und des zweiten Schaltelements (Q2) verbunden ist, ein Ausgangsende des Betriebsverstärkers ein Spannungsdetektionsende bildet.

2. System nach Anspruch 1, das **dadurch gekennzeichnet ist, dass** der Widerstand des ersten Widerstands gleich dem des zweiten Widerstands ist.

3. System nach Anspruch 1, das **dadurch gekennzeichnet ist, dass** die Detektionsschaltung ferner einen ersten Kondensator (C1), einen zweiten Kondensator (C2), einen dritten Widerstand (R3) und einen vierten Widerstand (R4) umfasst,

wobei der erste Kondensator und der dritte Widerstand parallel verbunden sind, um eine erste Parallelschaltung zu bilden, ein Ende der ersten Parallelschaltung mit dem nicht invertierenden Eingangsende des Betriebsverstärkers verbunden ist und das andere Ende der ersten Parallelschaltung mit dem Abschirmerdungsende verbunden ist,
der zweite Kondensator und der vierte Widerstand parallel verbunden sind, um eine zweite Parallelschaltung zu bilden, ein Ende der zweiten Parallelschaltung mit dem invertierenden Eingangsende des Betriebsverstärkers verbunden ist und das andere Ende der zweiten Parallelschaltung mit dem Ausgangsende des Betriebsverstärkers verbunden ist.

4. System nach Anspruch 3, das **dadurch gekennzeichnet ist, dass** der Widerstand des dritten Widerstands gleich dem des vierten Widerstands ist und der Kapazitätswert des ersten Kondensators gleich dem des zweiten Kondensators ist.

5. System nach Anspruch 1, das **dadurch gekennzeichnet ist, dass** das erste Schaltelement und das zweite Schaltelement zwei Schaltrohre an einem beliebigen Brückenarm einer einphasigen Vollbrückenwechselrichterschaltung oder einer dreiphasigen Vollbrückenwechselrichterschaltung sind.

6. System nach Anspruch 1, das **dadurch gekennzeichnet ist, dass** durch Detektieren der Spannung an dem Ausgangsende des Betriebsverstärkers und gemäß dem Widerstand des ersten Widerstands und des zweiten Widerstands der Wert des Isolierungswiderstands gegenüber Erdung berechnet werden kann.

7. System nach Anspruch 1, das **dadurch gekennzeichnet ist, dass** die Detektionsschaltung ferner einen Chip zum Steuern des Ein- oder Ausschaltens des ersten Schaltelements und des zweiten Schaltelements umfasst und der Chip ferner dazu konfiguriert ist, gemäß der Spannung an dem Ausgangsende des Betriebsverstärkers den Isolierungswiderstand gegenüber Erdung zu berechnen.

8. System nach Anspruch 5, das **dadurch gekennzeichnet ist, dass** es ferner einen invertierenden Steuerchip umfasst, der dazu konfiguriert ist, Schaltrohre in der Vollbrückenwechselrichterschaltung zum Ein- oder Ausschalten zu steuern, und wobei der invertierende Steuerchip ferner dazu konfiguriert ist, gemäß einem Widerstand des ersten Widerstands und des zweiten Widerstands in der Detektionsschaltung und der Spannung an dem Ausgangsende des Betriebsverstärkers den Isolierungswiderstand gegenüber Erdung der Photovoltaikanordnung zu berechnen.

9. Verfahren zum Detektieren des Isolierungswiderstands gegenüber Erdung ($R_P$, $R_N$) basierend auf dem System nach einem der Ansprüche 1-8, das **dadurch gekennzeichnet ist, dass** das Verfahren die folgenden Schritte umfasst:

S1: Steuern des Ausschaltens des ersten Schaltelements (Q1) und des Einschaltens des zweiten Schaltelements (Q2), um eine erste Spannung an dem Ausgangsende des Betriebsverstärkers zu detektieren; Steuern des Einschaltens des ersten Schaltelements (Q1) und des Ausschaltens des zweiten Schaltelements (Q2), um eine zweite Spannung an dem Ausgangsende des Betriebsverstärkers zu detektieren;
S2: gemäß der Ausgangsspannung der Photovoltaikanordnung, einem ersten Widerstandswert des ersten Widerstands (R1), einem zweiten Widerstandswert des zweiten Widerstands (R2), der ersten Spannung und der zweiten Spannung, Berechnen des Werts des Isolierungswiderstands gegenüber Erdung ($R_P$, $R_N$).

10. Verfahren zum Detektieren des Isolierungswiderstands gegenüber Erdung nach Anspruch 9, das **dadurch gekennzeichnet ist, dass** der Isolierungswiderstand einen ersten Isolierungswiderstand und einen zweiten Isolierungswiderstand umfasst und S2 Berechnen des Werts des Isolierungswiderstands gegenüber Erdung gemäß der folgenden Formel umfasst:

$$\frac{U1}{R1 + R2} + \frac{U1}{R_N} = \frac{U - U1}{R_P} \, ,$$

$$\frac{U2}{R1 + R2} + \frac{U2}{R_P} = \frac{U - U2}{R_N}$$

, wobei U1 der erste Spannungswert ist, U2 der zweite Spannungswert ist, U die Ausgangsspannung der Photovoltaikanordnung ist, R1 der erste Widerstandswert ist, R2 der zweite Widerstandswert ist, $R_P$ der erste Isolierungswiderstandswert ist und $R_N$ der zweite Isolierungswiderstandswert ist.

11. Verfahren zum Detektieren des Isolierungswiderstands gegenüber Erdung nach Anspruch 9, das **dadurch gekennzeichnet ist, dass**, unter der Annahme, dass der Widerstand des ersten Widerstands gleich dem des zweiten Widerstands ist, S2 Berechnen des Werts des Isolierungswiderstands gegenüber Erdung gemäß der folgenden Formel umfasst:

$$\frac{U1}{2*R1}+\frac{U1}{R_N}=\frac{U-U1}{R_P},$$

$$\frac{U2}{2*R1}+\frac{U2}{R_P}=\frac{U-U2}{R_N}$$

, wobei U1 der erste Spannungswert ist, U2 der zweite Spannungswert ist, U die Ausgangsspannung der Photovoltaikanordnung ist, R1 der erste Widerstandswert ist, $R_P$ der erste Isolierungswiderstandswert ist und $R_N$ der zweite Isolierungswiderstandswert ist.

12. Verwendung des Systems nach einem der Ansprüche 1-8, das für einen Photovoltaikwechselrichter oder ein Photovoltaiksystem ausgelegt ist.

## Revendications

1. Système de détection de la résistance d'isolement à la terre ($R_P$, $R_N$) d'un réseau photovoltaïque, qui est **caractérisé en ce que**,

le système comprend un circuit inverseur et un circuit de détection, dans lequel le circuit de détection comprend un premier résister (R1), un deuxième résister (R2) et un amplificateur opérationnel, le circuit inverseur est connectable à un réseau photovoltaïque, et le circuit inverseur comprend un premier élément de commutation (Q1) et un second élément de commutation (Q2) connectés en série ;
dans lequel une extrémité du premier résister (R1) est connectée à une extrémité d'entrée non inverseuse de l'amplificateur opérationnel, l'autre extrémité du premier résister (R1) est connectée à l'extrémité de mise à la terre de la résistance d'isolement (RP, RN) à détecter ; et
une extrémité du deuxième résister (R2) est connectée à une extrémité d'entrée inverseuse de l'amplificateur opérationnel, l'autre extrémité du deuxième résister (R2) est connectée à une extrémité de connexion intermédiaire du premier élément de commutation (Q1) et du second élément de commutation (Q2) ; une extrémité de sortie de l'amplificateur opérationnel forme une extrémité de détection de tension.

2. Système selon la revendication 1, qui est **caractérisé en ce que**, la résistance du premier résister est égale à celle du deuxième résister.

3. Système selon la revendication 1, qui est **caractérisé en ce que**, le circuit de détection comprend en outre un premier condensateur (C1), un second condensateur (C2), un troisième résister (R3) et un quatrième résister (R4),

dans lequel le premier condensateur et le troisième résister sont connectés en parallèle pour former un premier circuit parallèle, une extrémité du premier circuit parallèle est connectée à l'extrémité d'entrée non inverseuse de l'amplificateur opérationnel, et l'autre extrémité du premier circuit parallèle est connectée à l'extrémité de mise à la terre de blindage ;
le second condensateur et le quatrième résister sont connectés en parallèle pour former un second circuit parallèle, une extrémité du second circuit parallèle est connectée à l'extrémité d'entrée inverseuse de l'amplificateur opérationnel, et l'autre extrémité du second circuit parallèle est connectée à l'extrémité de sortie de l'amplificateur opérationnel.

4. Système selon la revendication 3, qui est **caractérisé en ce que**, la résistance du troisième résister est égale à celle du quatrième résister, et la valeur de capacité du premier condensateur est égale à celle du second condensateur.

5. Système selon la revendication 1, qui est **caractérisé en ce que**, le premier élément de commutation et le second élément de commutation sont deux tubes de commutation sur n'importe quel bras de pont d'un circuit inverseur en pont complet monophasé ou d'un circuit inverseur en pont complet triphasé.

6. Système selon la revendication 1, qui est **caractérisé en ce que**, en détectant la tension à l'extrémité de sortie de l'amplificateur opérationnel, et selon les résistances du premier résister et du deuxième résister, la valeur de la résistance d'isolement à la terre peut être calculée.

7. Système selon la revendication 1, qui est **caractérisé en ce que**, le circuit de détection comprend en outre une puce pour commander le premier élément de commutation et le second élément de commutation pour les activer ou désactiver, et la puce est en outre configurée pour, selon la tension à l'extrémité de sortie de l'amplificateur opérationnel, calculer la résistance d'isolement à la terre.

8. Système selon la revendication 5, qui est **caractérisé en ce que**, il comprend en outre une puce de commande d'inversion, qui est configurée pour commander des tubes de commutation dans le circuit inverseur en pont complet pour les activer ou désactiver, et la puce de commande d'inversion est en outre configurée pour, selon les résistances du premier résister et du deuxième résister dans le circuit de détection et la tension à l'extrémité de sortie de l'amplificateur opérationnel, calculer la résistance d'isolement à la terre du réseau photovoltaïque.

9. Procédé de détection de la résistance d'isolement à la terre ($R_P$, $R_N$) basé sur le système selon l'une quelconque des revendications 1 à 8, qui est **caractérisé en ce que**, le procédé comprend les étapes suivantes :
S1 : la commande du premier élément de commutation (Q1) pour le désactiver et du second élément de commutation (Q2) pour l'activer, afin de détecter une première tension à l'extrémité de sortie de l'amplificateur opérationnel ; la commande du premier commutateur (Q1) pour l'activer et du second élément de commutation (Q2) pour le désactiver, afin de détecter une seconde tension à l'extrémité de sortie de l'amplificateur opérationnel :
S2 : selon la tension de sortie du réseau photovoltaïque, une première valeur de résistance du premier résister (R1), une seconde valeur de résistance du deuxième résister (R2), la première tension et la seconde tension, calculer la valeur de la résistance d'isolement à la terre ($R_P$, $R_N$).

10. Procédé de détection de la résistance d'isolement à la terre selon la revendication 9, qui est **caractérisé en ce que**, la résistance d'isolement comprend une première résistance d'isolement et une seconde résistance d'isolement, et S2 comprend le calcul de la valeur de la résistance d'isolement à la terre selon la formule suivante :

$$\frac{U1}{R1+R2} + \frac{U1}{R_N} = \frac{U-U1}{R_p},$$

$$\frac{U2}{R1+R2} + \frac{U2}{R_p} = \frac{U-U2}{R_N};$$
, dans lequel, U1 est la première valeur de tension, U2 est la seconde valeur de tension, U est la tension de sortie du réseau photovoltaïque, R1 est la première valeur de résistance, R2 est la seconde valeur de résistance, $R_p$ est la première valeur de résistance d'isolement, et $R_N$ est la seconde valeur de résistance d'isolement.

11. Procédé de détection de la résistance d'isolement à la terre selon la revendication 9, qui est **caractérisé en ce que**, en supposant que la résistance du premier résister est égale à celle du deuxième résister, S2 comprend le calcul de la valeur de la résistance d'isolement à la terre selon la formule suivante :

$$\frac{U1}{2*R1} + \frac{U1}{R_N} = \frac{U-U1}{R_p},$$

$$\frac{U2}{2*R1} + \frac{U2}{R_p} = \frac{U-U2}{R_N},$$
, dans lequel, U1 est la première valeur de tension, U2 est la seconde valeur de tension, U est la tension de sortie du réseau photovoltaïque, R1 est la première valeur de résistance, $R_P$ est la première valeur de résistance d'isolement, et $R_N$ est la seconde valeur de résistance d'isolement.

12. Utilisation du système selon l'une quelconque des revendications 1 à 8, adapté à un onduleur photovoltaïque ou à un système photovoltaïque.

Figure 1

Figure 2

Figure 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2015084654 A1
- US 2018011149 A1
- CN 105938162 B
- CN 103904994 B